Europäisches Patentamt

European Patent Office

Office européen des brevets

(19)

(11) Publication number: **0 120 083
B1**

# EUROPEAN PATENT SPECIFICATION

(12)

(45) Date of publication of patent specification: **10.05.89**

(51) Int. Cl.⁴: **C 23 C 18/16, H 05 K 3/42**

(21) Application number: **83903439.4**

(22) Date of filing: **27.09.83**

(86) International application number:
**PCT/US83/01483**

(87) International publication number:
**WO 84/01392 12.04.84 Gazette 84/10**

(54) **APPARATUS AND METHOD FOR ELECTROLESS PLATING.**

(30) Priority: **27.09.82 US 423821**

(43) Date of publication of application:
**03.10.84 Bulletin 84/40**

(45) Publication of the grant of the patent:
**10.05.89 Bulletin 89/19**

(84) Designated Contracting States:
**AT BE CH DE FR GB LI LU NL SE**

(56) References cited:
**GB-A-2 100 520
US-A-3 158 500
US-A-3 513 020
US-A-3 895 137
US-A-4 143 618
US-A-4 262 044**

**No relevant documents have been disclosed**

(73) Proprietor: **EDT Technology, Inc.
605 West County Road E
Shoreview Minnesota 55126 (US)**

(72) Inventor: **SCHRAMM, Charles, H.
3200 Park Avenue
Bridgeport, CT 06604 (US)**

(74) Representative: **Ström, Tore et al
Ström & Gulliksson AB Studentgatan 1 P.O. Box
4188
S-203 13 Malmö (SE)**

EP 0 120 083 B1

## Description

### Background of the invention

Electroless plating is a process that is well-known in the art for chemically depositing metal on metallic or non-metallic substrates. The electroless plating of copper is of considerable commercial importance in the electronics industry, particularly in the fabrication of printed circuitry used in electronic equipment. In fabricating printed circuitry, a thin layer of copper must first be deposited by electroless plating onto a nonconductive surface such as plastic, to make the surface electrically conductive. This thin conductive surface serves as an electrically conductive flash layer receptive to further deposition of metal by electrodeposition, which is used to build up a plate to a desired thickness for an actual conductive circuit pattern.

The typical prior art electroless plating process generally comprises the steps of treating the surface of the article to be plated by immersing the article in a bath containing a stannous salt; catalyzing the article by immersing it in solution for providing catalytic nucleating centers on the surface of the article; and treating the catalyzed surface of the article by immersing it in an electroless solution including a salt of the metal and a reducing agent. The steps of the electroless plating process typically are performed in a tank that is filled with a static bath corresponding to the desired step of the electroless plating process. The article to be plated, such as a printed circuit board substrate, is immersed in the static bath until the desired treatment is completed.

In the prior art, the process steps are performed sequentially by draining the tank and refilling it with the constituent bath of each succeeding step until the entire process is completed. Alternatively, the process may be performed by maintaining a series of tanks and sequentially immersing the article to be plated in each tank containing the appropriate bath.

There are several serious drawbacks to using the above-described prior art static systems of electroless deposition. First, static systems are characteristically slow. For example, it can take longer than a day to plate a single printed circuit board substrate with only one mil of copper by electroless deposition where static baths are used. This seriously inhibits the volume production of plated articles, such as is demanded in the commercial manufacture of printed circuit boards.

Second, the chemical constituents in electroless plating baths are continuously being consumed. Thus, these baths are in a constant state of change. It is extremely difficult to control the chemical stability of a constituent bath to maintain a relatively high plating rate over long plating periods as required when prior art systems are employed. Consequently, the static baths tend to become unstable and decompose with use. Therefore, chemical stability, which is important in order to maintain a relatively high plating rate for the duration of the plating process, is lost.

Third, with respect to the plating of through-holes, the quality and speed of electroless plating of tiny through-holes in printed circuit boards is severely limited by prior art electroless deposition systems. Typically, in printed circuit board fabrication, electroless metal is deposited as a uniform surface coating or in a predetermined pattern on a nonconductive substrate. The substrate is generally copper-clad plastic laminate, having a copper foil laminated to one or both substrate surfaces. In double-sided printed circuit boards, and in multilayered printed circuit board packages, connections are provided between conductive surfaces by means of through-holes drilled in the laminate. The walls of the through-holes are made conductive with an electroless coating. Such holes, because of their minute size, can be very difficult to access with the constituent baths of the electroless process using a system of immersion in a static baths. Consequently non-uniform or incomplete electroless plating of through-holes may result. This significantly reduces the quality of the printed circuit board produced, and increases the number of boards that ultimately must be rejected.

Also, in prior art systems hydrogen gas produced during the plating process may accumulate in the through-holes, as well as in tiny pits and pores in the printed circuit board surface, which further interferes with the electroless plating process. Additionally, because of the resulting amount of included hydrogen in electroless metal deposits, the plate may exhibit poor ductility, and therefore easily can be fractured in later use by vibration or bending.

GB—A—2,100,520 discloses a method of making conductive clearance holes in a support board for electric circuits wherein conductive ink is passed through holes in the board which is inserted between stencils, said ink flowing from one chamber at one side of the board to another chamber at the other side of the board. Once a predetermined quantity of ink has been transferred from one chamber to the other, the process is reversed. Thus, a complex masking and "closed" system for treating selected-masked areas of a substrate are used.

Accordingly, it is a primary object of the present invention to provide a new and novel method and apparatus for electrolessly plating circuit boards with minute through-holes which substantially increases the reaction rates of the constituent electroless plating baths, and that deposits a given thickness of metal onto the board in a fraction of the time required in prior art systems.

Another object of the present invention is to provide a method and apparatus for electroless plating that provides complete and uniform plating of the through-holes in the boards to be plated.

It is an additional object of the present invention to provide a method and apparatus for electroless plating that results in a uniform and ductile metallic layer on the entire surface of the article, such as on both sides of double sided printed circuit boards.

## Summary of the invention

An electroless plating apparatus and method for coating printed circuit boards with minute through-holes is described. The apparatus comprises a tank for receiving a constituent bath therein, manifolds disposed in the tank and having walls facing each other, said walls being mutually spaced and forming a plurality of ports therethrough, means adapted to support the printed circuit board to be electrolessly plated so that it is at least partially immersed in the constituent bath between said walls and substantially parallel to said walls, pumping means for delivering the bath through the ports of one of said manifolds so that it impinges on one surface of the printed circuit board and withdrawing the bath through the ports of the other one of said manifolds so that it is sucked away from the opposite surface of the printed circuit board and means for oscillating said supporting means in a back and forth motion substantially in parallel with said walls.

Operation of the apparatus according to the method of the invention comprises the steps of at least partially immersing the board to be electrolessly plated in a constituent bath, creating a flow of the bath so that it impinges on one surface of the board from a location spaced therefrom, sucking away the bath from the opposite surface of the board at a location spaced therefrom, and causing an oscillating motion of the board in the direction substantially perpendicularly to the direction of flow of the bath.

By applying the invention a considerable increase in the rate of metal deposition on the surface of the board over prior art systems is realized. Further, the stability of the constituent chemical baths is maintained, and uniformity of the thickness and quality of metal deposited onto the board surface is achieved. In the printed circuit boards which may have thousands of holes through their surface, a uniform and continuous deposit results on the entire surface of each hole wall. A high quality deposit is accomplished because the pressure difference created across the holes insures that they are fully accessed with each chemical constituent bath used in the electroless plating process.

Regardless of the prior art method of electroless deposition that may be employed, by using the inventive apparatus to create a pressure difference in the electroless solution and other constituent solutions with respect to the board being plated, a substantial increase in the plating rate and in the quality of metal deposition can be accomplished.

Other objects and many attendant advantages of the invention will become more apparent upon a reading of the following description together with the drawings in which like reference numerals refer to like parts throughout and in which:

## Brief description of the drawings

Figure 1 is a perspective view of an electroless plating apparatus showing the pumps, interconnecting pipe and associated equipment which are incorporated in the present invention;

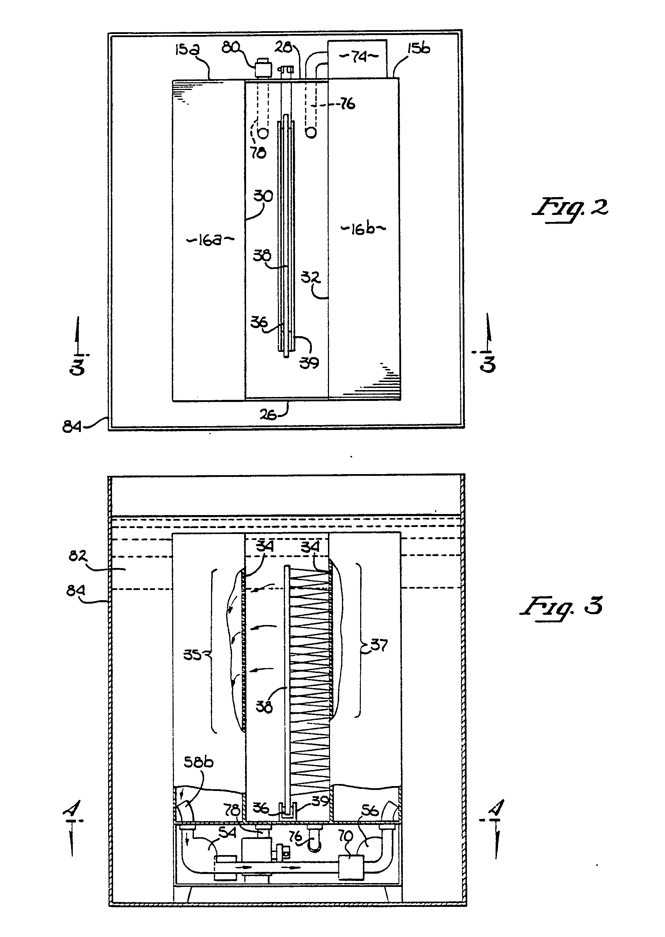

Figure 2 is a top view of the entire apparatus shown immersed in a larger independent tank into which constituent baths of the process are contained;

Figure 3 is a sectional view of the apparatus taken along line 3—3 that shows the apparatus immersed in an independent tank operating on an article with fluid following in a single direction;

Figure 4 is a top view of the apparatus taken along line 4—4 illustrating detail of the pumping arrangement, piping, and drain connections; and

Figure 5 is a sectional view taken along line 5—5 showing the rocker arm mechanism used for oscillating the article in the preferred embodiment of the present invention.

## Detailed description of the drawings

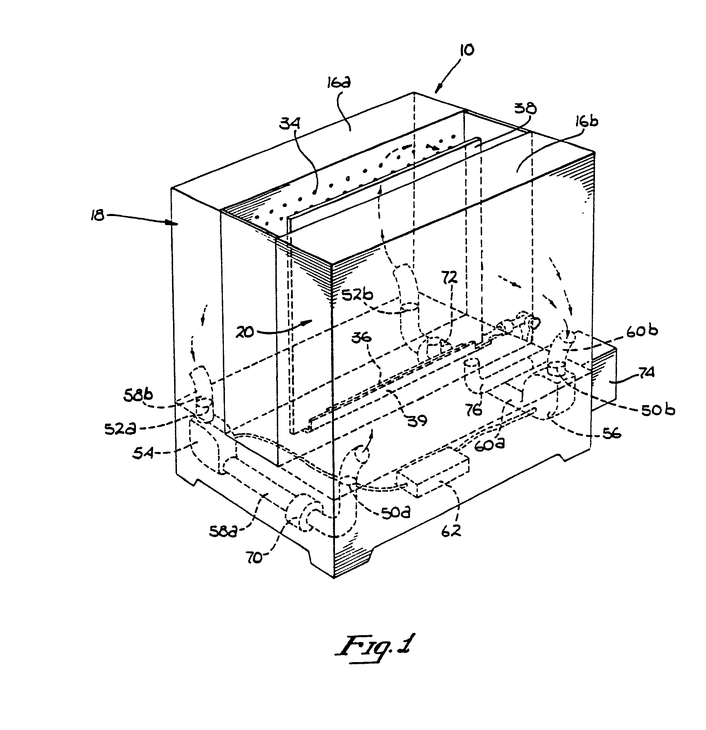

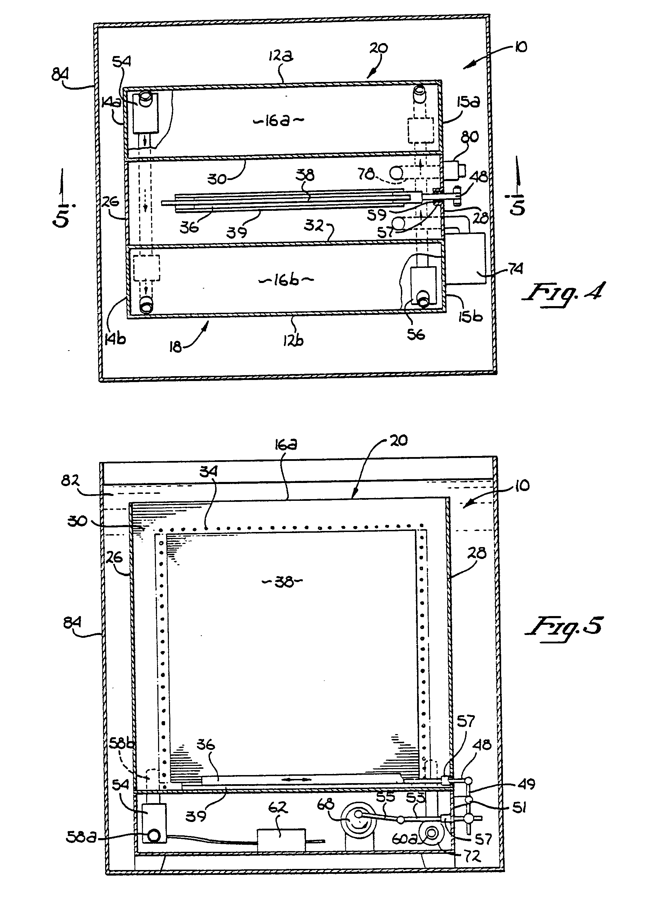

Referring generally to Figure 1, a perspective view of the preferred embodiment of the present invention is shown. This embodiment is comprised of a rectangular tank 10 having a pair of rectangular manifolds 18 and 20 disposed at opposite sides thereof. As more clearly illustrated in Figure 4, which is a top sectional view taken along line 4—4, the sides and base of the tank 10, respectively, also form the ends 12a and 12b, sides 14a, 14b, 15a, and 15b and bases 16a, and 16b of the manifolds. The entire apparatus is composed of plastic, such as polyvinyl chloride, but other suitable materials may alternatively be used.

Again referring to Figure 1, on the inward facing walls 30 and 32 of the manifolds 18 and 20, respectively, are a plurality of nozzles 34. The nozzle arrangement of the presently preferred embodiment comprises a pair of matrices 35 and 37, most clearly shown in Figure 3 each having approximately 700 holes of .02″ diameter, evenly spaced apart along the surface of the inward facing wall 30 and 32 of each manifold.

Still referring to Figure 4, the storage volume of the tank 10 is defined by the inward facing walls 30 and 32 of the manifolds and the tank side portions 26 and 28. The article to be plated is disposed centrally within the tank, and is immersed to a desired level in the constituent bath which fills the tank, as will be described later in greater detail.

Referring generally to Figure 1, and as further shown in Figure 5, in the presently preferred embodiment, a bracket 36 is provided to support the printed circuit board 38 in a position substantially perpendicular to the tank base and parallel to the inward facing walls 30 and 32 of the manifolds. The bracket is slideable in a track 39 centrally mounted to the tank base so that the printed circuit board 38 can be oscillated in a back-forth motion perpendicular to the direction of flow of constituent bath through the nozzles matrices 35 and 37. As best shown in Figure 5, oscillation of the bracket is accomplished by a motor driven rocker arm mechanism, the drive link 48 of which is connected to one end of the sliding bracket 36, as will later be described in further detail.

Referring once again to Figure 1, the base of each manifold is provided with a pair of ports 50a and 50b and 52a and 52b respectively, disposed at opposite ends of each manifold. The pumps 54 and 56 deliver and withdraw fluid through the ports in each manifold through discharge lines 58a and 60a and suction lines 58b and 60b. The discharge and inlet lines protrude through the manifold ports and are directed away from the nozzles to prevent unwanted turbulance near the nozzles which could interfere with fluid flow therethrough. Each manifold is otherwise completely closed on all sides, so that fluid may be pumped under pressure into the tank 10 or sucked out of the tank through the nozzles 34. Two pumps are provided and are operated alternately to allow for periodic reversal of flow direction. The pumps are, therefore, arranged to operate in opposite directions, with only one pump operating at a time. The discharge lines 58b and 60b and suction lines 58a and 60a may optionally be provided with check valves as necessary to prevent recirculation of fluid through a non-operative pump while the other pump is in operation.

Although in the pump arrangement just described each pump is connected to independent lines which are connected to the holes in the floor of each manifold, it should be appreciated that the present invention is not limited to this arrangement, and that a variety of pump arrangement well known in the art could serve equally as well.

The pumps 54 and 56 are connected to an automatic switching unit 62 which alternately turns on and shuts off each pump. This switching unit may be provided with an adjustable timer so that the frequency at which the pumps are switched on and off may be controlled within some preselected time interval.

Having described the primary structural features of the present invention, the operation of the apparatus and the inventive process will now be described, and particular features of the invention will be described in greater detail.

First, a printed circuit board 38 is mounted onto the sliding bracket 36 as shown in Figure 1. The tank 10 is then filled with the constituent bath of the particular process step to be performed. During the filling process, the pumps 54 and 56 may be turned on to insure that the pump lines and manifolds become completely filled with fluid entering through the nozzle matrices 35 and 37.

During operation of the apparatus, as illustrated in Figure 3, the constituent bath is pumped through the first pump 54 into the first manifold 18, such that it is discharged through the nozzles 34 of the matrix 37 at high pressure. Since each hole in the nozzle matrix operates as an individual nozzle, a high velocity stream of fluid impinges onto a corresponding local area of the printed circuit board 38 being plated. Simultaneously, fluid is sucked through the nozzle matrix 35 of the second manifold 20 away from corresponding local areas of the printed circuit board 38. The solution is then pumped through the suction inlet line 58b of the first pump 54, and is discharged through discharge line 58a back into the first manifold 18. The constituent bath is thereby continuously recirculated through the electroless plating apparatus.

The combined action of the fluid impinging under pressure against one side of the board and of being sucked away from the opposite side of the board results in a continuous flow of the bath through the numerous through-holes in the printed circuit board being plated. This cooperating impingement-suction action of the constituent bath, which operates on the printed circuit board surfaces and through the through-holes, contributes substantially to the quality and plating rate of electroless metal deposited on through-hole walls and on the surface of the printed circuit board. It is also contributed to the chemical stability of the constituent bath. Further, the continuous throughput of the constituent bath ensures complete immersion and contact with areas of the board that are often starved of the bath in prior art systems. Additionally, hydrogen bubbles which accumulate in through-holes or in pits and pores of the board are eliminated as a result of the suction and impingement action created in the apparatus.

The foregoing describes the operation of the apparatus with the constituent bath flowing in one direction. In the preferred embodiment of the present invention, the direction of flow is reversed at preselected intervals. By periodically reversing flow direction, the constituent bath alternately impinges on opposite sides of the article. Flow reversal helps to insure that a uniform electroless deposit is achieved over surfaces of the board. A time interval of between five and thirty seconds is presently employed for this purpose.

Additionally, the board itself is oscillated back and forth at right angles to the impinging fluid streams. This oscillation is necessary because printed circuit boards, may have more than 20,000 holes distributed randomly over their surface. Many of the holes may not line up with any of the individual nozzles in the nozzle matrix. By oscillating the board, all holes may directly be impinged by a stream of fluid. Further, oscillation insures that the plate is uniform over flat surfaces, i.e., that a raised "image" of the matrix of impinging fluid streams does not result on the article.

As shown in Figure 5, oscillation of the board is accomplished in the preferred embodiment by a motorized rocker arm mechanism. A drive link 48 links the sliding bracket 36 to rocker arm 49 throughguide 57. Rocker arm 49 pivots about pivot 51 upon each rotation of a motor driven disk 68 via pus rod 53 and connecting rod 55. Each rotation of the disc 68 thus causes a back and forth translational motion of the bracket 36 in track 39. The board 38 mounted on the bracket 36, is thereby oscillated back and forth.

In line filters 70 and 72, mounted in the pump interconnecting lines, are also provided. These filters remove particulate matter from the bath. Filtration is particularly important because even minute dirt particles will act as nucleating centers for electroless plating solution, causing unwanted precipitation and destabilization of the constituent bath.

It has been found that improved stability of the constituent bath may also be achieved by bubbling air up through the tank 10. Thus, as clearly shown in Figure 1, in the presently preferred embodiment an air pump 74 is provided to pump air through an air line 76 directly into the tank.

The present invention offers significant advantages over the prior art systems of electroless plating. Such prior art systems typically suspend the board to be plated in static baths. Sometimes the board is agitated mechanically within the bath. Nevertheless, mechanical agitation alone does not appreciably improve the rate of reaction, the stability of the bath, or the uniformity of the electroless plate. Nor does such agitation or printed circuit boards help to access tiny through-holes to ensure that through-hole walls are thoroughly and uniformly plated. Further, in static bath systems, the printed circuit boards may be suspended perpendicular to the floor of the tank, or multiple boards may be supported parallel to one another at various angles from perpendicular through to the horizontal position within the tank solution. When the boards are suspended perpendicularly to the tank floor, the plating may be thicker at the lower portion of the board due to downward precipitation of the electroless solution as a result of gravity. Similarly, when boards are stacked at an angle or horizontally, the upper side of the board may be plated with a thicker electroless plate than the bottom side of the board, since the electroless solution will tend to precipitate away from the underside of the board. However, by continuously circulating the solution through the tank, as in the present invention, and by using the suction-impingement arrangement described herein, uniform plating of the entire board, including the walls of through-holes, is achieved in a fraction of the time previously required.

In order to obtain optimal results using the inventive apparatus, each step having a given chemical constituent solution used in the electroless plating process should be performed in the electroless plating apparatus of the present invention.

The chemical solutions used in the electroless plating process, and the order in which the object to be plated is bathed in such solutions, are well known in the prior art. It should be appreciated that the order in which these steps are performed may vary somewhat, and the chemical constituents may also vary depending on the particular prior art process that is employed. For a detailed description of prior art electroless plating processes using noble metals, see for example, Shipley, Jr., US Patent No. 3,011,920 issued December 5, 1961, or Grunwald, US Patent No. 3,694,250 issued September 26, 1972.

The following describes one embodiment of the series of steps which is used for the electroless deposition of copper in the present invention. However, the present invention is not limited to depositing copper, and numerous other metals, including nickel, cobalt, palladium, platinum, gold, and silver may also be electrolessly placed. Each step is conducted in the electroless plating apparatus which provides several additional operative steps including moving the constituent bath with respect to the printed circuit board and creating a pressure difference therein, as earlier described.

The steps of the electroless plating process are performed one by one by draining the tank 10 of one constituent bath and filling it with the constituent bath the succeeding step. It should be appreciated that a drain line 78 having a valve 80 is provided for this purpose. Alternatively, a separate apparatus may be used for each constituent bath used in the process. In this way, for each step of the process, the board can be sequentially placed in the tank of each apparatus containing the respective constituent bath of the process. This avoids the necessity of repeatedly draining and filling a single apparatus to perform each step in the electroless plating process, and a measurable increase in efficiency and production may therefore be achieved.

Additionally, it should also be appreciated that the entire electroless plating apparatus may be immersed into a separate tank 78 which contains a constituent bath 82 of the process, as shown in Figures 3 and 5. Thus, a series of tanks which together contain all the baths used in the process can be continuously maintained. Then, the apparatus supporting the board to be plated can be easily moved from tank to tank to perform the successive process steps.

Turning now to the inventive process, first, the board to be plated is treated with hydrochloric acid. Next, the board may optionally be rinsed with water to remove the excess hydrochloric acid. The board is then activated with a colloidal catalytic solution of stannous chloride and palladium chloride. The palladium chloride is a salt catalytic to the deposition of copper and is used for catalyzing the surface of the board to provide catalytic nucleating centers on the board's surface. Once again, the board may optionally be rinsed with water. Next, the board is treated with an accelerator, which is an organic material having a high molecular weight, such as polyethylene glycol. This substance forms an adhesive-like coating on the board to be plated. The board is then rinsed with water. Finally, the board is placed in a solution that includes copper sulfate, Rochelle salt and formaldehyde. This final step is considered the "deposition" or "plating" step. The copper sulfate, which is a water soluble metal salt, is a source of cupric ions. The Rochelle salt operates as a complexing agent making the cupric ions available as needed to the reducing action of the reducing agent. In the preferred embodiment of the present invention, the complexing agent is EDTA, manufactured by the Dow Chemical Corporation. The formaldehyde operates as a reducing agent to reduce the cupric ions to metallic form.

Optimal improvement in the quality of the electrobaths is realized if the inventive apparatus is used to create the aforementioned pressure difference and agitation in each bath used in the electroless plating process. It should be appreciated, however, that improved electroless deposition may be achieved even if the inventive apparatus is used only in connection with the deposition step. To achieve best results, however, it is recommended that the inventive apparatus be used with all constituent baths of the process.

**Claims**

1. Electroless plating apparatus for coating printed circuit boards having minute through-holes, comprising a tank (10) for receiving a constituent bath therein, manifolds (18, 20) disposed in the tank and having walls facing each other, said walls (30, 32) being mutually spaced and forming a plurality of ports (34) therethrough, means (36) adapted to support the printed circuit board (38) to be electrolessly plated so that it is at least partially immersed in the constituent bath between said walls and substantially parallel to said walls, pumping means (54, 56) for delivering the bath through the ports of one of said manifolds so that it impinges on one surface of the printed circuit board and withdrawing the bath through the ports of the other one of said manifolds so that it is sucked away from the opposite surface of the printed circuit board and means (48, 49, 53, 55, 68) for oscillating said supporting means (36) in a back and forth motion substantially in parallel with said walls.

2. Electroless plating apparatus as in claim 1 wherein said ports are distributed corresponding to the area to be electrolessly plated.

3. Electroless plating apparatus as in claim 1 or 2 wherein means (62) are provided for periodically reversing the direction of the flow obtained by said pump means between said walls (30, 32) of the manifolds (18, 20).

4. Electroless plating apparatus as in claim 1 wherein said means (36) for supporting the printed circuit board to be electrolessly plated has first and second planar opposing surfaces substantially parallel to and between said manifolds (18, 20), to receive the board therebetween.

5. Electroless plating apparatus as in claim 4 wherein said means for supporting the printed circuit board to be electrolessly plated comprises a substantially U-shaped bracket (36) for receiving the board, mounted on a track (39) on the floor of the tank (10) to be slidably translated along the track.

6. Electroless plating apparatus as in claim 4 or 5 wherein the ports (34) in said walls (30, 32) of the manifolds (18, 20) comprise a matrix of closely spaced holes.

7. Electroless plating apparatus as in any of claims 4 to 6 wherein said pump means (54, 56) comprise a pair of oppositely directed centrifugal pumps each interconnected independently to the manifolds (18, 20).

8. Electroless plating apparatus as in claim 1 wherein means (70, 72) are provided for removing particulates from the bath.

9. Electroless plating apparatus as in claim 8 wherein said means for removing particulates from the bath comprise at least one filter (70; 72) disposed in at least one fluid line between the manifolds (18, 20).

10. Electroless plating apparatus as in claim 1 wherein means (74, 76) are provided for introducing a gas into the bath received by the tank (10).

11. Electroless plating apparatus as in claim 10 wherein said means for introducing a gas comprises an air pump (74) interconnected to and in fluid communication with the tank (10) for bubbling air through the bath received by the tank.

12. Method for coating printed circuit boards with minute through-holes by electroless plating comprising the steps of at least partially immersing the board to be electrolessly plated in a constituent bath, creating a flow of the bath so that it impinges on one surface of the board from a location spaced therefrom, sucking away the bath from the opposite surface of the board at a location spaced therefrom, and causing an oscillating motion of the board in a direction substantially perpendicularly to the direction of flow of the bath.

13. Method as in claim 12 wherein the direction of flow of the bath is periodically reversed.

14. Method as in claim 13 wherein a gas is introduced into the bath.

15. Method as in claim 14 wherein the step of introducing a gas comprises injecting air into the bath.

16. Method as in claim 13 wherein particulates are removed from the bath.

17. Method as in claim 16 wherein the step of removing particulates comprises pumping the bath through a filter.

**Patentansprüche**

1. Stromlose Plattiervorrichtung zum Überziehen gedruckter Schaltungsplatinen mit winzigen Durchgangslöchern, bestehend aus einem Behälter (10) zur Aufnahme eines Komponentenbades, in Behälter angeordneten Verteilern (18, 20) mit einander gegenüberliegenden Wänden (30, 32), die in gegenseitigem Abstand angeordnet sind und mehrere Durchlässe (34) aufweisen, einer Einrichtung (36) zur Halterung der stromlos zu plattierenden gedruckten Schaltungsplatine (38), so daß diese zumindest teilweise zwischen den Wänden und im wesentlichen parallel zu den Wänden in das Komponentenbad eingetaucht ist, einer Pumpeinrichtung (54, 56) zum Zuleiten des Bades durch die Durchlässe eines der Verteiler, sodaß es auf eine Seite der gedruckten Schaltungsplatine auftrifft, und zum Ableiten des Bades durch die Durchlässe des anderen Verteilers, sodaß es von der gegenüberliegenden Seite der gedruckten Schaltungsplatine abgesaugt wird, und einer Schwingeinrichtung (48, 49, 53, 55, 68) zum Hin- und Herbewegen der Halterungseinrichtung (36) im wesentlichen parallel zu den Wänden.

2. Stromlose Plattiervorrichtung nach Anspruch 1, dadurch gekennzeichnet, daß die Durchlässe entsprechend der stromlos zu plattierenden Fläche verteilt sind.

3. Stromlose Plattiervorrichtung nach Anspruch 1 oder 2, dadurch gekennzeichnet, daß eine Einrichtung (62) zur periodischen Umkehr der von der Pumpeinrichtung zwischen den Wänden (30, 32) der Verteiler (18, 20) bewirkten Strömungsrichtung vorgesehen ist.

4. Stromlose Plattiervorrichtung nach Anspruch 1, dadurch gekennzeichnet, daß die Einrichtung (36) zur Halterung der stromlos zu plattierenden gedruckten Schaltungsplatine eine erste und eine zweite ebene Oberfläche besitzt, welche Oberflächen einander gegenüberliegen und im wesentlichen parallel zu und zwischen den Verteilern (18, 20) zur Aufnahme der Platine verlaufen.

5. Stromlose Plattiervorrichtung nach Anspruch 4, dadurch gekennzeichnet, daß die Einrichtung zur Halterung der stromlos zu plattierenden gedruckten Schaltungsplatine aus einem im wesentlichen U-förmigen Bügel (36) aur Aufnahme der Platine besteht, der auf einer Führung (39) am Boden des Behälters (10) angebracht und entlang der Führung gleitend verschiebbar ist.

6. Stromlose Plattiervorrichtung nach Anspruch 4 oder 5, dadurch gekennzeichnet, daß die Durchlässe (34) in den Wänden (30, 32) der Verteiler (18, 20) aus einer Matrix nahe nebeneinander angeordneter Löcher bestehen.

7. Stromlose Plattiervorrichtung nach den Ansprüchen 4 bis 6, dadurch gekennzeichnet, daß die Pumpeinrichtung (54, 56) aus einem Paar gegensinnig gerichteter Zentrifugalpumpen besteht, die unabhängig voneinander mit den Verteilern (18, 20) verbunden sind.

8. Stromlose Plattiervorrichtung nach Anspruch 1, dadurch gekennzeichnet, daß eine Einrichtung (70, 72) zur Entfernung von Teilchen aus dem Bad vorgesehen ist.

9. Stromlose Plattiervorrichtung nach Anspruch 8, dadurch gekennzeichnet, daß die Einrichtung zur Entfernung von Teilchen aus dem Bad wenigstens einen in zumindest einer Strömungsmittelleitung zwischen den Verteilern (18, 20) angeordneten Filter (70; 72) aufweist.

10. Stromlose Plattiervorrichtung nach Anspruch 1, dadurch gekennzeichnet, daß eine Einrichtung (74, 76) zur Einleitung eines Gases in das vom Behälter (10) aufgenommene Bad vorgesehen ist.

11. Stromlose Plattiervorrichtung nach Anspruch 10, dadurch gekennzeichnet, daß die Einrichtung zur Einleitung eines Gases eine Luftpumpe (74) aufweist, die mit dem Behälter (10) verbunden ist sowie mit diesem in Strömungsverbindung steht und zur Einleitung von Luftblasen in das vom Behälter aufgenommene Bad dient.

12. Verfahren zum Überziehen gedruckter Schaltungsplatinen mit winzigen Durchgangslöchern durch stromloses Plattieren, bestehend aus den Schritten des zumindest teilweisen Eintauchens der stromlos zu plattierenden Platine in ein Komponentenbad, der Schaffung einer Strömung in dem Bad, so daß dieses auf eine Seite der Platine von einer räumlich entfernten Stelle auftrifft, des Absaugens des Bades von der gegenüberliegenden Seite der Platine an einer im Abstand befindlichen Stelle und der Bewirkung einer Schwingbewegung der Platine in einer im wesentlichen zur Strömungsrichtung des Bades senkrechten Richtung.

13. Verfahren nach Anspruch 12, dadurch gekennzeichnet, daß die Strömungsrichtung des Bades periodisch umgekehrt wird.

14. Verfahren nach Anspruch 13, dadurch gekennzeichnet, daß ein Gas in das Bad eingeleitet wird.

15. Verfahren nach Anspruch 14, dadurch gekennzeichnet, daß der Schritt des Einleitens eines Gases im Einblasen von Luft in das Bad besteht.

16. Verfahren nach Anspruch 13, dadurch gekennzeichnet, daß Teilchen aus dem Bad entfernt werden.

17. Verfahren nach Anspruch 16, dadurch gekennzeichnet, daß der Schritt des Entfernens von Teilchem im Pumpen des Bades durch einen Filter besteht.

**Revendications**

1. Appareil de metallisation sans courant électrique pour revêtir des plaquettes de circuits imprimés comportant de petits trous traversants, comprenant un réservoir (10) pour recevoir un bain constituant, des collecteurs (18, 20) disposés dans le réservoir, et ayant des parois se faisant face l'une l'autre, lesdites parois (30, 32) étant espacées l'une de l'autre et présentant plusieurs orifices (34) qui les traversent, des moyens (36) adaptés à soutenir la plaquette (38) de circuits imprimés à métalliser par un procédé sans courant de manière qu'elle soit au moins partiellement plongée dans le bain constituant entre lesdites parois et à peu près parallèle à celles-ci, des moyens (54, 56) de pompage pour distribuer le bain à travers les orifices de l'un desdits collecteurs de manière qu'il frappe une surface de la plaquette de circuits imprimés, et pour retirer le bain à travers les orifices de l'autre desdits collecteurs de manière qu'il soit aspiré en s'éloignant de la surface opposée de la plaquette de circuits imprimés, et des moyens (48, 49, 53, 55, 68) pour faire osciller lesdits moyens (36) de support suivant un mouvement de va-et-vient à peu près parallèle auxdites parois.

2. Appareil de métallisation sans courant suivant la revendication 1, dans lequel lesdits orifices sont répartis de manière qui correspond à l'étendue de la surface à métalliser par un procédé sans courant.

3. Appareil de métallisation sans courant suivant la revendication 1 ou 2, dans lequel des moyens (62) sont prévus pour inverser périodiquement le sens de l'écoulement obtenu par lesdits moyens de pompage entre lesdites parois (30, 32) des collecteurs (18, 20).

4. Appareil de métallisation sans courant suivant la revendication 1, dans lequel lesdits moyens (36) pour soutenir la plaquette de circuits imprimés à métalliser par procédé sans courant comportent des première et seconde surfaces opposées planes à peu près parallèles auxdits collecteurs (18, 20) et situées entre ceux-ci afin de recevoir la plaquette entre-elles.

5. Appareil de métallisation sans courant suivant la revendication 4, dans lequel lesdits moyens pour soutenir la plaquette de circuits imprimés à métalliser sans courant comprennent un support (36) de forme à peu près en U pour recevoir la plaquette, monté sur une glissière (39) sur le fond du réservoir (10) afin d'être déplacé en translation par coulissement suivant la glissière.

6. Appareil de métallisation sans courant suivant la revendication 4 ou 5, dans lequel les orifices (34) dans lesdites parois (30, 32) des collecteurs (18, 20) sont constitués par une matrice de trous rapprochés.

7. Appareil de métallisation sans courant suivant l'une quelconque des revendications 4 à 6, dans lequel lesdits moyens de pompage (54, 56) comprennent deux pompes centrifuges dirigées en sens opposé interconnectées chacune indépendamment aux collecteurs (18, 20).

8. Appareil de métallisation sans courant suivant la revendication 1, dans lequel des moyens (70, 72) sont prévus pour extraire des particules du bain.

9. Appareil de métallisation sans courant suivant la revendication 8, dans lequel lesdits moyens pour extraire des particules du bain comprennent au moins un filtre (70, 72) disposé dans au moins un conduit de fluide entre les collecteurs (18, 20).

10. Appareil de métallisation sans courant suivant la revendication 1, dans lequel des moyens (74, 76) sont prévus pour introduire un gaz dans le bain conenu dans le réservoir (10).

11. Appareil de métallisation sans courant suivant la revendication 10, dans lequel lesdits moyens pour introduire un gaz comprennent une pompe à air (74) reliée au réservoir (10) et en communication fluidique avec celui-ci pour faire barboter de l'air à travers le bain contenu dans le réservoir.

12. Procédé pour revêtir des plaquettes de circuits imprimés comportant de petits trous traversants par métallisation sans courant, comprenant les phases consistant à: plonger au moins partiellement la plaquette à métalliser sans courant dans un bain constituant, créer un écoulement du bain de manière qu'il frappe une surface de la plaquette à partir d'un point espacé de celle-ci, aspirer le bain en l'éloignant de la surface opposée de la plaquette vers un point espacé de celle-ci, et provoquer un mouvement d'oscillation de la plaquette dans une direction à peu près perpendiculaire au sens de l'écoulement du bain.

13. Procédé suivant la revendication 12, dans lequel le sens de l'écoulement du bain est périodiquement inversé.

14. Procédé suivant la revendication 13, dans lequel un gaz est introduit dans le bain.

15. Procédé suivant la revendication 14, dans lequel le phase d'introduction d'un gaz comprend l'injection d'air dans le bain.

16. Procédé suivant la revendication 13, dans lequel des particules sont extraites du bain.

17. Procédé suivant la revendication 16, dans lequel la phase d'extraction des particules comprend le pompage du bain à travers un filtre.

*Fig. 1*

1

*Fig. 2*

*Fig. 3*

Fig.4

Fig.5